# EUROPÄISCHE PATENTSCHRIFT

(11) **EP 3 191 564 B1**
(45) Veröffentlichungstag und Bekanntmachung des Hinweises auf die Patenterteilung: **01.07.2020**
(21) Anmeldenummer: 15777612.1
(22) Anmeldetag: 10.09.2015
(51) Int. Cl.: C09K 11/77

(54) **LICHTEMITTIERENDE VORRICHTUNG**
LIGHT EMITTING DEVICE
DISPOSITIF LUMINESCENT

(30) Priorität: 10.09.2014 DE 102014113068
(43) Veröffentlichungstag der Anmeldung: 19.07.2017
(73) Patentinhaber: Seaborough IP I B.V., 1019 AG Amsterdam (NL)
(72) Erfinder: JÜSTEL, Thomas, 58455 Witten (DE); PLEWA, Julian, 48167 Münster (DE); MÖLLER, Stephanie, 48565 Steinfurt (DE); HONOLD, Jürgen, NL-1019 JC Amsterdam (NL)
(74) Vertreter: Hoyng Rokh Monegier LLP
(86) Internationale Anmeldenummer: PCT/EP2015/070742
(87) Internationale Veröffentlichungsnummer: WO 2016/038149

(56) Entgegenhaltungen:
- WO-A1-2005/078048
- DE-A1-102007 039 260
- US-A1- 2004 145 307
- US-A1- 2006 169 986
- US-A1- 2011 182 056

## Beschreibung

Die vorliegende Erfindung bezieht sich auf das Gebiet der Licht emittierenden Vorrichtungen, insbesondere von LEDs.

Bei LEDs ist in den letzten Jahren aufgrund der steigenden Anforderungen festzustellen, dass von der klassischen blauen LED zu den sogenannten "GaN-on-GaN" oder auch "n-Pola", "non-polar" oder "semi-polar" -Technologien gewechselt wird, welche in der Lage sind, bei höheren Stromdichten zu arbeiten und daraus eine wesentlich höhere Lichtausbeute/-leistung zu generieren. Zur Erzeugung von sichtbarer Strahlung, insbesondere (warm-)weißem Licht, werden darüber hinaus entsprechende Konvertermaterialien benötigt, die die UV-A- oder blaue Primärstrahlung, die vom Hableiterchip erzeugt wird, so umwandeln, dass Licht der jeweiligen Farbe erzeugt werden kann.

Alternativ zu den oben erwähnten LED-Technologie werden auch andere LED-Technologien in Betracht gezogen, die in der Lage sind durch die Realisierung höherer elektrischer Ströme pro mm² Licht-emittierender Fläche besonders hohe Strahlungsleistungen zu generieren, wie beispielsweise die so genannten "3D"-LED oder auch Nano-LED oder Nanowire-LED genannten LED-Technologien.

Alternativ werden auch Lösungen in Betracht gezogen, die auf Lasertechnik basieren, d.h. bei denen die UV-A- oder blaue Primärstrahlung mittels Lasern erzeugt wird

Bei Verwendung einer blauen LED in Kombination mit einem gelben Leuchtstoff kann (kalt-) weißes Licht erzeugt werden, dessen Farbwiedergabeindex vergleichsweise niedrig ist. Zur Erreichung eines hohen Farbwiedergabeindexes ist die Anwendung eines RGB-Systems notwendig, wobei im Falle eines blau emittierenden Halbleiterelements ein grün- und ein rot emittierender und im Falle eines UV-A emittierenden Halbleiterelements ein blau, ein grün oder gelb und ein rot emittierender Leuchtstoff notwendig sind.

Diese neuen Techniken, insbesondere die n-pola-Technik wird üblicherweise mit den bestehenden Konvertermaterialien eingesetzt, was jedoch den Nachteil hat, dass aufgrund der bei diesen Konvertermaterialien bestehenden meist hohen Sättigung, gerade was rotemittierende Konvertermaterialien angeht, die Vorteile der n-pola-Technik nicht optimal ausgenutzt werden kann.

Es besteht somit die Aufgabe, eine veränderte Licht emittierende Vorrichtung bereitzustellen, die in der Lage ist, diese Nachteile zumindest teilweise zu überwinden. Demgemäß wird eine Licht emittierende Vorrichtung vorgeschlagen, umfassend ein UV-A oder blaue Primärstrahlung emittierendes Halbleiterbauelement mit einer Strahlungsleistung von ≥ 4 Wopt/mm² sowie ein Konvertermaterial welches überwiegend ein Material enthält, ausgewählt aus der Liste enthaltend:
A₃AE₂(Ln_{1-x-y}EUₓ)₃(MO₄)₈:RE_{y}
ALn_{1-x-y}EuₓM₂O₈:RE_{y}
(Ln_{1-x-y}Euₓ)₂M₂O₉:RE_{2y}
(Ln_{1-x-y}Euₓ)₂M₃O₁₂:RE_{2y}
(Ln_{1-x-y}Euₓ)₂M₄O₁₅:RE_{2y}
(Ln_{1-x-y}EUₓ)₆MO₁₂:RE_{6y}

Molybdänhaltige Phosphore sind u.a. aus der DE 10 2007 039 260 bekannt.

(AE_{1-2-y}EuₓA_{x+y})₃MO₆:RE_{3y}
oder Mischungen daraus, wobei - für jede Struktur jeweils unabhängig voneinander - A ein Erdalkalimetall, d.h. ausgewählt aus der Gruppe Lithium, Natrium, Kalium, Rubidium, Cäsium oder Mischungen daraus bedeutet, AE ein Erdalkalimetall, d.h. ausgewählt aus der Gruppe enthaltend Magnesium, Kalzium, Strontium, Barium oder Mischungen daraus, Ln ein Seltenerdmetall ausgewählt aus der Gruppe enthaltend Scandium, Yttrium, Lanthan, Gadolinium und Lutetium oder Mischungen daraus, M Molybdän, Wolfram oder Mischungen daraus, RE ein Seltenerdmetall ausgewählt aus der Gruppe Terbium, Dysprosium, Praseodym, Neodym oder Mischungen daraus, wobei 0 <x ≤ 1 und 0 ≤y ≤ 0,05 ist.

Im Sinne der vorliegenden Erfindung bedeutet "überwiegend" dabei ≥90% (mol/mol), bevorzugt ≥95% (mol/mol), noch bevorzugt ≥97% (mol/mol) sowie am meisten bevorzugt ≥99% (mol/mol).

Im Sinne der vorliegenden Erfindung bedeutet "Wopt" die optische Leistung (engl. "power radiance").

RE ist dabei eine Co-Dotierung, d.h. bevorzugt ist y ≥ 0.001 und ≤0.05, noch bevorzugt y ≥ 0.01 und ≤0.03. Alternativ sind jedoch ebenso Strukturen bevorzugt, die kein RE enthalten, dies sind ebenfalls bevorzugte Ausführungsformen der Erfindung, d.h. y=0

Ein besonders bevorzugtes Material ist A₃AE₂(Ln_{1-x-y}Euₓ)₃(MO₄)₈:RE_{y}. Dies hat sich bei vielen Anwendungen als besonders stabil herausgestellt.

Überraschenderweise wurde festgestellt, dass bei Verwendung eben dieser Eu³⁺ aktivierten Konvertermaterialien zusammen mit entsprechenden UV-A oder blau emittierenden Halbleiterbauelementen emittiertem UV-A oder blauem hochenergetischem Licht keine oder nur eine geringfügige Sättigung erfolgt, so dass die Effizienz der Licht emittierenden Vorrichtung drastisch erhöht ist. Unter keiner oder nur geringfügiger Sättigung wird dabei insbesondere verstanden, dass das Konvertermaterial bei einer Anregungsdichte von 1 kW/mm2 weniger als 10% sättigt.

Eu³⁺ ist ein vergleichsweise langsamer Aktivator. Die Abklingzeit t_{1/10} beträgt ca. 3 ms, d.h. 3 ms nach dem Anregungspuls sind 90% der Eu³⁺-Ionen wieder im Grundzustand und können einen neuen Lumineszenzprozess durchlaufen. Erwartungsgemäß sollten somit Eu³⁺-Leuchtstoffe bei steigenden Anregungsdichten also an ihre Kapazitätsgrenze im Bezug auf die Konversionsrate stoßen und ein Sättigungsverhalten zeigen, so dass bei steigender Anregungsdichte keine weitere Steigerung der Emissionsintensität beobachtet werden sollte. Für die in der Lichttechnik gängigen Eu³⁺ aktivierten Rotemitter wie (Y,Gd)₂O₃:Eu³⁺ oder (Y,Gd)BO₃:Eu³⁺ ist dies auch der Fall.

Diese Sättigung tritt überraschenderweise aber bei der erfindungsgemäßen Vorrichtung nicht oder nur sehr geringfügig auf, so dass die durch die neuen Halbleiterbauelement-Konzepte erreichbare Anregungsdichte vollständig in Photonen der gewünschten Wellenlänge umgesetzt werden kann und somit eine drastische Erhöhung der Gesamtlichtleistung erreicht werden kann.

Außerdem bietet die erfindungsgemäße Vorrichtung bei den meisten Ausführungsformen und konkreten Ausgestaltungen einen oder mehrere der folgenden Vorteile:
- Die Anregungsmaxima der Konvertermaterialien liegen im Bereich um 400 nm sowie im Bereich um 460 nm und somit passgenau zur Emission der n-Pola UV-A- oder blauemittierenden Halbleiterelemente.
- Die unter Schutz gestellten molybdän- und/oder wolframhaltigen Verbindungen sind durch einen besonders hohen und für Europium nicht typischen Absorptionsquerschnitt im UV-A- und blauen Spektralbereich gekennzeichnet.
- Die rot emittierenden Konvertermaterialien zeigen üblicherweise eine scharfe Emissionsbande meist zwischen 610 und 630 nm mit einer Halbwertsbreite von weniger als 10 nm
- Die Konvertermaterialien haben meist Eu³⁺ auf einer nicht-inversionssymetrischen kristallographischen Position, so dass die ⁵D₀-⁷F₂ - Übergänge (welche für die Emissionen zwischen 610 und 630 nm verantwortlich sind) gegenüber den ⁵D₀-⁷F₁ - Übergängen bevorzugt sind, welche üblicherweise in den hier der Erreichung eines hohen Farbwiedergabindexes entgegenstehenden Emissionen zwischen 590 und 600nm resultieren würden.
- Die Konvertermaterialien haben oftmals einen geringen Schmelzpunkt von unterhalb 1100°C, was deren Verwendung in keramischer Form sehr erleichtert.
- Die mit dem Betrieb unter höheren Anregungsdichten einhergehende höhere thermische Belastung des Konvertermaterials kann mit keramischen Lumineszenzkonversionselementen besonders gut kontrolliert werden, da sich keramische Lumineszenzkonversionselemente durch eine höhere thermische Leitfähigkeit und damit einen verbesserte Ableitung der thermischen Energie im Vergleich zu polymerbasierten Lumineszenzkonversionselementen auszeichnen.

Gemäß einer bevorzugten Ausführungsform der Erfindung umfasst die Vorrichtung ein UV-A oder blaue Primärstrahlung emittierendes Halbleiterbauelement betrieben mit einem elektrischen Strom (oder Bestromung, oder Stromdichte) von ≥ 2 A/mm². Dies hat sich in der Praxis bewährt. Besonders bevorzugt ist der Betrieb mit einem elektrischen Strom (oder Strom-Dichte oder Bestromung) von ≥ 3 A/mm².

Gemäß einer bevorzugten Ausführungsform der Erfindung umfasst die Vorrichtung ein UV-A oder blaue Primärstrahlung emittierendes Halbleiterbauelement mit einer Strahlungsleistung von ≥ 6 Wopt/mm², noch bevorzugt ≥ 8 Wopt/mm², sowie besonders bevorzugt von ≥ 10 Wopt/mm².

Gemäß einer bevorzugten Ausführungsform der Erfindung ist das UV-A oder blaue Primärstrahlung emittierende Halbleiterbauelement ein Laser und/oder basiert darauf. Gemäß einer bevorzugten Ausführungsform der Erfindung ist das UV-A oder blaue Primärstrahlung emittierende Halbleiterbauelement auf der n-Pola Technologie aufgebaut oder basiert darauf.

Im Sinne der vorliegenden Erfindung bedeutet und/oder umfasst der Term "n-Pola-Technologie" bzw. deren synonym verwendbaren Terme "GaN-on-GaN-Technologie", Non-Polar"- oder auch "Semi-Polar"- Technologie insbesondere ein Licht emittierendes Halbleiterbauelement, das durch eine im Vergleich mit konventionellen auf GaN-on-Sapphire-Technologie (oder "GaN-on-Siliconcarbide" oder "GaN-on-Silicon") basierenden Leuchtdioden deutlich reduzierte Defektdichte (GaN-on-Sapphire: 5 x 10⁸ cm⁻²; GaN-on-GaN: 1 x 10⁴ bis 1 x 10⁶ cm⁻²) deutlich höhere Stromdichten ohne den von konventionellen LEDs bekannten Droop-Effekt erlaubt. Insbesondere werden darunter Halbleiterbauelemente verstanden, die gemäß Schmidt et al. Japanese Journal of Applied Physics, 2007, vol 46. No. 7, L126-128 und/oder Hashimoto et al. Nature Materials, 2007, 568-571 und/oder entsprechend analogen Techniken hergestellt wurden.

Während die externe Quantenausbeute bei konventionellen Licht emittierenden Halbleiterbauelementen mit GaN-on-Sapphire-Technologie bei hohen Stromdichten rapide abnimmt, bleibt die externe Quantenausbeute bei GaN-on-GaN-Halbleiterbauteilen nahezu konstant bei Werten um 90 %, was bedeutet, dass die Steigerung der Stromdichte in einer nahezu proportionalen Steigerung der Lichtausbeute resultiert und somit wesentlich höhere Helligkeiten bei gleichbleibender Bauteilgröße ermöglicht.

Die n-Pola-Technologie ist auch unabhängig von dem Wopt-Wert von eigenständiger erfinderischer Bedeutung.

Demgemäß wird zur Lösung der obigen Aufgabe eine Licht emittierende Vorrichtung vorgeschlagen, umfassend ein UV-A oder blaue Primärstrahlung emittierendes Halbleiterbauelement gemäß der n-Pola- Technologie sowie ein Konvertermaterial welches überwiegend ein Material enthält, ausgewählt aus der Liste enthaltend:
A₃AE₂(Ln_{1-x-y}EUₓ)₃(MO₄)₈:RE_{y}
ALn_{1-x-y}EuₓM₂O₈:RE_{y}
(Ln_{1-x-y}Euₓ)₂M₂O₉:RE_{2y}
(Ln_{1-x-y}Euₓ)₂M₃O₁₂ :RE_{2y}
(Ln_{1-x-y}Euₓ)₂M₄O₁₅:RE_{2y}
(Ln_{1-x-y}Euₓ)₆MO₁₂:RE_{6y}
(AE_{1-2x-y}EuₓA_{x+y})₃MO₆:RE_{3y}
oder Mischungen daraus. Alle zuvor geschilderten und im Folgenden erläuterten Ausgestaltungsformen können *mutatis mutandis* auch auf diese Vorrichtung angewendet werden.

Gemäß einer bevorzugten Ausführungsform der vorliegenden Erfindung liegt das Konvertermaterial in Pulverform vor.

Gemäß einer bevorzugten Ausführungsform der vorliegenden Erfindung liegt das Konvertermaterial als keramisches Material vor.

Der Ausdruck "keramisches Material" im Sinne der vorliegenden Erfindung bedeutet und/oder umfasst dabei insbesondere ein kompaktes kristallines oder polykristallines Material mit einer kontrollierten Menge an Poren oder porenfrei.

Der Ausdruck "polykristallines Material" im Sinne der vorliegenden Erfindung bedeutet und/oder umfasst dabei insbesondere ein Material mit einer Volumendichte von größer 90 Prozent der Hauptkomponente, bestehend zu mehr als 80 Prozent aus einzelnen Kristalldomänen, wobei jede Kristalldomäne einen Durchmesser von 0,1- 1.0 µm und abweichende kristallographische Orientierung besitzt. Die einzelnen Kristalldomänen können über amorphes oder glasartiges Material oder über zusätzliche kristalline Bestandteile miteinander verbunden bzw. verdünnt sein.

Gemäß einer bevorzugten Ausführungsform der vorliegenden Erfindung besitzt das kristalline Material eine Dichte von ≥90% bis ≤ 100% der theoretischen Dichte. Dies hat sich für viele Anwendungen der vorliegenden Erfindung als vorteilhaft herausgestellt.

Gemäß einer bevorzugten Ausführungsform der vorliegenden Erfindung umfasst die Licht emittierende Vorrichtung zusätzlich noch ein grün emittierendes Material.

Im Sinne der vorliegenden Erfindung bedeutet und/oder umfasst der Term "grün emittierend" ein Material, welches bei geeigneter Anregung eine Emissionsbande zwischen 500 nm und 550 nm besitzt.

Dabei sind folgende Strukturen für das grün emittierende Material insbesondere bevorzugt: BaMgAl₁₀O₁₇:Eu²⁺,Mn²⁺, (Sr₁₋ₓBaₓ)Si₂N₂O₂:Eu²⁺, (Sr₁₋ₓBaₓ)₂SiO₄:Eu²⁺, (Sr₁₋ₓBaₓ)₃SiO₅:Eu²⁺, (Sr₁₋ₓBaₓ)Ga₂S₄:Eu²⁺, (Lu₁₋ₓYₓ)₃(Al_{1-y}Ga_{y})₅O₁₂:Ce³⁺, (Lu₁₋ₓYₓ)₃(Al_{1-y}Sc_{y})₅O₁₂:Ce³⁺ oder Mischungen dieser Materialien.

Insbesondere bevorzugt sind grün emittierende Materialien ausgewählt aus der Gruppe enthaltend BaMgAl₁₀O₁₇:Eu²⁺,Mn²⁺, (Sr₁₋ₓBaₓ)Si₂N₂O₂:Eu, (Sr₁₋ₓBaₓ)₂SiO₄:Eu, (Lu₁₋ₓYₓ)₃(Al_{1-y}Ga_{y})₅O₁₂:Ce, (Lu₁₋ₓYₓ)₃(Al_{1-y}Sc_{y})₅O₁₂:Ce oder Mischungen dieser Materialien.

Gemäß einer bevorzugten Ausführungsform der vorliegenden Erfindung umfasst die Licht emittierende Vorrichtung zusätzlich noch ein gelb emittierendes Material.

Im Sinne der vorliegenden Erfindung bedeutet und/oder umfasst der Term "gelb emittierend" ein Material, welches bei geeigneter Anregung eine Emissionsbande zwischen 550 und 590 nm besitzt.

Dabei sind folgende Strukturen insbesondere bevorzugt: Ba₂Si₅N₈:Eu²⁺, (Ca₁₋ₓSrₓ)Si₂N₂O₂:Eu²⁺, (Y₁₋ₓGdₓ)₃(Al_{1-y}Ga_{y})₅O₁₂:Ce³⁺, (Y₁₋ₓTbₓ)₃(Al_{1-y}Ga_{y})₅O₁₂:Ce³⁺, SrLi₂SiO₄:Eu²⁺, (Ca₁₋ₓSrₓ)₂SiO₄:Eu²⁺, (Ca₁₋ₓSrₓ)₃SiO₅:Eu²⁺ oder Mischungen dieser Materialien.

Insbesondere bevorzugt sind gelb emittierende Materialien ausgewählt aus der Gruppe enthaltend Ba₂Si₅N₈:Eu²⁺, (Ca₁₋ₓSrₓ)Si₂N₂O₂:Eu²⁺, (Y₁₋ₓGdₓ)₃(Al_{1-y}Ga_{y})₅O₁₂:Ce³⁺, (Y₁₋ₓTbₓ)₃(Al_{1-y}Ga_{y})₅O₁₂:Ce³⁺ oder Mischungen dieser Materialien.

Gemäß einer bevorzugten Ausführungsform der vorliegenden Erfindung umfasst die Licht emittierende Vorrichtung zusätzlich noch ein blau emittierendes Material.

Im Sinne der vorliegenden Erfindung bedeutet und/oder umfasst der Term "blau emittierend" ein Material, welches bei geeigneter Anregung eine Emissionsbande zwischen 420 und 500 nm besitzt.

Dabei sind folgende Strukturen insbesondere bevorzugt: (Ba₁₋ₓSrₓ)MgAl₁₀O₁₇:Eu²⁺, (Ba₁₋ₓSrₓ)Mg₃Al₁₄O₂₅:Eu²⁺, (Sr,Ca,Mg)₂Si₂O₆:Eu²⁺, CaAl₂O4:Eu²⁺, (Ba₁₋ₓSrₓ)Al₂Si₂O₈:Eu²⁺, (Ba₁₋ₓSrₓ)₆BP₅O₂₀:Eu²⁺, (Ca_{1-x-y}SrₓBa_{y})₅(PO₄)₃(F₁₋ₐCl_{y}):Eu²⁺, (Y,Gd)(Nb₁₋ₓTaₓ)O₄ oder Mischungen dieser Materialien.

Insbesondere bevorzugt sind blau emittierende Materialien ausgewählt aus der Gruppe enthaltend (Ba₁₋ₓSrₓ)MgAl₁₀O₁₇:Eu²⁺, (Ba₁₋ₓSrₓ)Mg₃Al₁₄O₂₅:Eu²⁺, (Ca_{1-x-y}SrₓBa_{y})₅(PO₄)₃(F₁₋ₐCl_{y}):Eu2⁺ oder Mischungen dieser Materialien

Die erfindungsgemäße Vorrichtung kann bei einer Vielzahl von konkreten topologischen Aufbauten bzw. Anwendungen eingesetzt werden, darunter - aber nicht darauf beschränkt - unter anderem die folgenden:
1. "Chip Coating": Der LED-Dice wird mit dem Leuchtstoffpulver beschichtet, anschließend werden Dice und Leuchtstoff mit einem transparenten Medium (Polymer oder neuestens auch Glas) überzogen.
2. "Leuchtstoffpulver in einer Polymer- oder Glas-Matrix": Das Leuchtstoffpulver wird mit Glas oder einem transparenten Polymer möglichst homogen vermischt und auf den Dice aufgebracht.
3.Mischung aus "Chip-Coating" und "Leuchtstoffpulver in einer Polymer- oder Glas-Matrix"
4. "Direkt aufgebrachte Leuchtstoffkeramik": Die Leuchtstoffkeramik wird als dünnes Plättchen direkt auf den LED-Dice aufgebracht, d.h. grundsätzlich ähnlich wie beim "Chip-Coating", allerdings in Keramikform.
5."Remotephosphor in Transmissionsanwendung": Die Leuchtstoffkeramik wird auf eine Reflexionskammer aufgesetzt, in der sich die LED oder der Laser befindet. Das Licht kann nur durch die Keramik hindurch entweichen (Transmission).
6."Remotephosphor in Re-Emissionsanwendung": Die Leuchtstoffkeramik wird auf einen reflektierenden Träger aufgebracht (oder wird rückseitig mit reflektierendem Material beschichtet), Die LED-Lichtquelle oder der Laser befindet sich in oder leicht seitlich der Abstrahlrichtung und strahlt auf die Remotephosphorkeramik. Das konvertierte Licht wird reemittiert in Richtung der Lichtquelle bzw. in Abstrahlrichtung, das durch die Keramik gelangte Licht (Transmission) wird durch die rückseitige Reflexionsschicht auch wieder in Abstrahlrichtung gelenkt. Das Licht kann also nur in die Re-Emissions-Richtung entweichen.

Selbstverständlich ist dem Fachmann klar, dass auch Abwandlungen und Kombinationen der oben beschriebenen Aufbauten verwendet werden können.

Die vorgenannten sowie die beanspruchten und in den Ausführungsbeispielen beschriebenen erfindungsgemäß zu verwendenden Bauteile unterliegen in ihrer Größe, Formgestaltung, Materialauswahl und technischen Konzeption keinen besonderen Ausnahmebedingungen, so dass die in dem Anwendungsgebiet bekannten Auswahlkriterien uneingeschränkt Anwendung finden können.

Weitere Einzelheiten, Merkmale und Vorteile des Gegenstandes der Erfindung ergeben sich aus den Unteransprüchen sowie aus der nachfolgenden Beschreibung der zugehörigen Zeichnung, in denen - beispielhaft - mehrere Ausführungsbeispiele der erfindungsgemäßen Vorrichtung dargestellt sind. In den Zeichnungen zeigt:
Fig. 1 einen sehr schematischen Querschnitt durch eine erste Ausführungsform einer erfindungsgemäßen Vorrichtung.
Fig. 2 eine sehr schematische Versuchsansicht zur Messung der Sättigung von Materialien.
Fig. 3 ein Diagramm welches die integrierte Emission gegen die Anregungsdichte eines entsprechenden Materials zeigt; sowie
Fig. 4 das Emissionsspektrum des Materials aus Fig. 3.

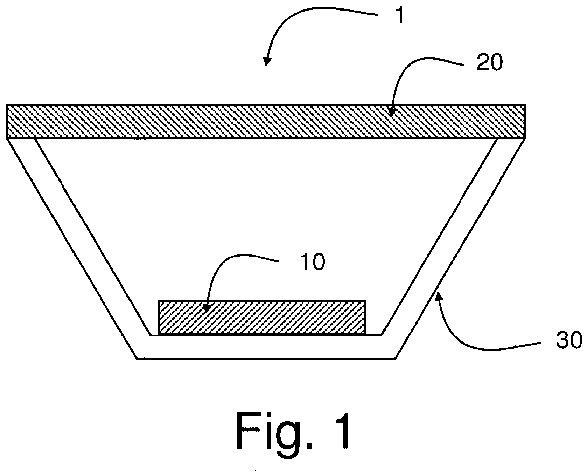

Fig. 1 zeigt eine erste Ausführungsform der erfindungsgemäßen Vorrichtung im Sinne einer "remote-phosphor"-Anwendung. Dies ist jedoch nicht beschränkend und für den Fachmann ist es selbstverständlich, dass auch andere Ausführungsformen denkbar sind. Lt. Fig. 1 umfasst die Vorrichtung 1 ein UV-A oder blauemittierendes Halbleiterbauelement 10, welches z.B. auf der nPola-Technik (GaN-on-GaN-Technologie) basiert. Alternativ kann das Halbleiterbauelement auch ein Laser sein, oder andere LED-Technologien die durch die Ermöglichung einer höheren Bestromung der Licht emittierenden Fläche eine höhere Strahlungsleistung pro mm² realisieren.

Das Halbleiterbauelement 10 ist in einem reflektierenden Gehäuse 30 angeordnet, oberhalb dessen sich das den rotemittierendenKonverter 20 enthaltende Lumineszenzkonversionselement befindet, das als Keramik ausgebildet ist.

Die Erfindung wird ausserdem anhand des folgenden Beispiels vorgestellt, welches rein illustrativ und nicht als beschränkend anzusehen ist.

### Beispiel I:

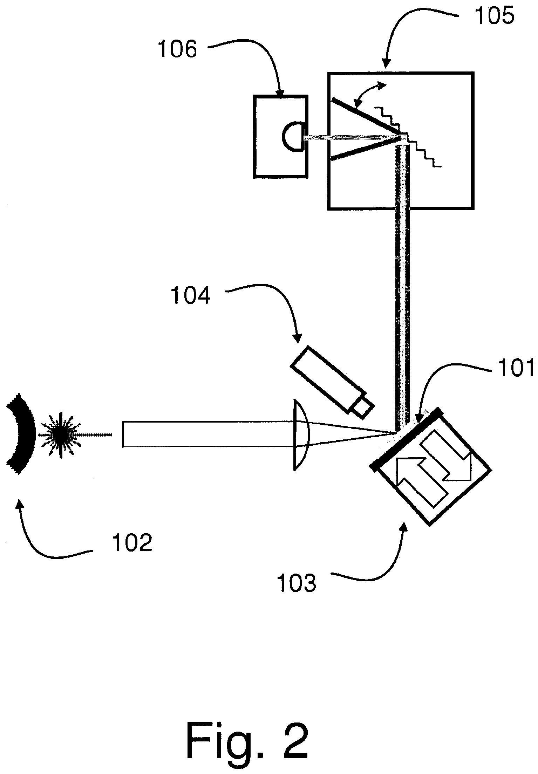

Die Figuren 2 bis 4 beziehen sich auf Li₃Ba₂La_{1.8}Eu_{.1.2}(MoO)₄, welches folgendermaßen hergestellt wurde:
- Synthese von Li₃Ba₂La_{1.8}Eu_{1.2}(MoO₄)₈

0.7894 g (4.000 mmol) BaCO₃, 2.3030 g (16.000 mmol) MoO₃, 0.2217 g (3.000 mmol) Li₂CO₃, 0.4223 g (1.200 mmol) Eu₂O₃ und 0.5865 g (1.800 mmol) La₂O₃ wurden in einem Mörser mit Aceton als Mahlhilfe gemörsert. Das erhaltene Pulver wurde getrocknet, in eine Porzellantiegel überführt und bei 800°C für 12 h an der Luft kalziniert. Der so erhaltene Kuchen wurde zermahlen und durch ein 36 µm Sieb gesiebt.

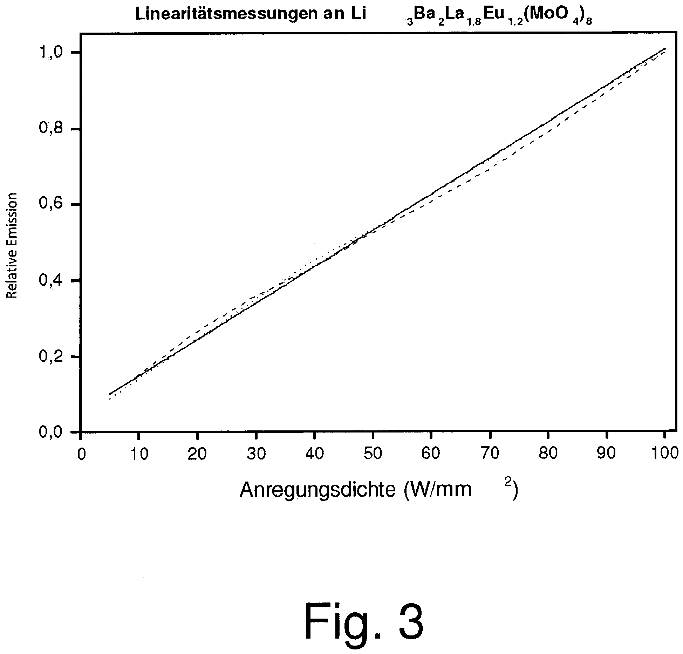

Fig. 2 zeigt eine sehr schematische Versuchsansicht zur Messung der Sättigung von Materialien, die zur Erstellung des Diagramms aus Fig. 3 verwendet wurde.

In der Versuchsansicht wird ein Probe 101 mit einer Laserdiode 102 (OBIS Laser 375 nm LX 50 mW) bestrahlt, deren Licht durch eine Linse 103 fokussiert wird. Dabei wird die Probe 101 durch den Kühler 105 entweder passiv (Silbersubstrat) oder aktiv (He-Kryostat) gekühlt.

Anschließend wird das Licht, nachdem es einen Monochromator 105 passiert hat, auf den Detektor 106 geleitet.

Fig. 3 zeigt ein Diagramm, in dem die relativen Emissionsintegrale über der Anregungsdichte bei Bestrahlung des Materials lt. Beispiel I aufgetragen ist. Dabei wurden sowohl ein Pulver (gestrichelte Linie) als auch eine Keramik (gepunktete Linie) vermessen.

In Fig. 3 ist deutlich zu sehen, dass die Kurve linear verläuft, d.h. dass keine oder nur nicht nennenswerte Sättigung auftritt.

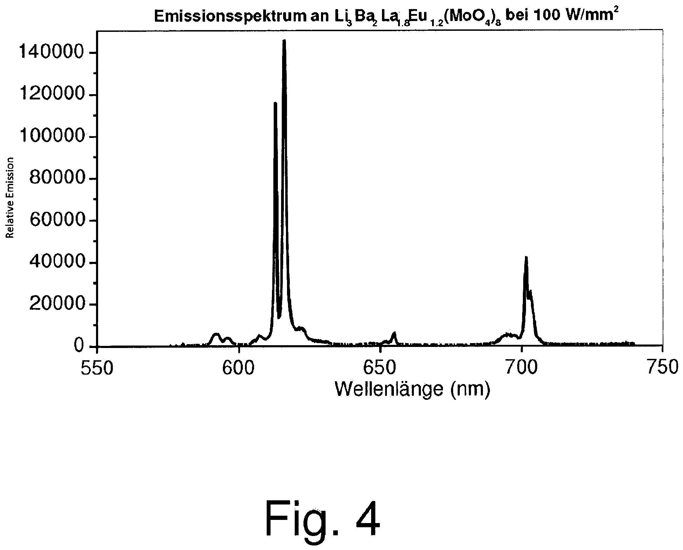

Fig. 4 zeigt das Emissionsspektrum des Materials aus Fig. 1, dabei ist deutlich zu sehen, dass das Material rot emittiert.

## Patentansprüche

1. Lichtemittierende Vorrichtung, umfassend ein UV-A oder blaue Primärstrahlung emittierendes Halbleiterbauelement mit einer Strahlungsleistung von ≥ 4 Wopt/mm² sowie ein Konvertermaterial welches überwiegend ein Material enthält, ausgewählt aus der Liste enthaltend:
ALn_{1-x-y}EuₓM₂O₈:RE_{y}
(Ln_{i-x-y}Euₓ)₂MO₆:RE_{2y}
(Ln_{i-x-y}Euₓ)₂M₂O₉:RE_{2y}
(Ln_{1-x-y}Euₓ)₂M₃O₁₂:RE_{2y}
(Ln_{1-x-y}Euₓ)₂M₄O₁₅:RE_{2y}
(Ln_{1-x-y}Euₓ)₆MO₁₂:RE_{6y}
(AE_{1-2x-y}EuₓA_{x+y})₃MO₆:RE_{3y}
A₃AE₂(Ln_{1-x-y}Euₓ)₃(MO₄)₈:RE_{y}
oder Mischungen daraus, wobei - für jede Struktur jeweils unabhängig voneinander - A ein Erdalkalimetall, d.h. ausgewählt aus der Gruppe Lithium, Natrium, Kalium, Rubidium, Cäsium oder Mischungen daraus bedeutet, AE ein Erdalkalimetall, d.h. ausgewählt aus der Gruppe enthaltend Magnesium, Kalzium, Strontium, Barium oder Mischungen daraus, Ln ein Seltenerdmetall ausgewählt aus der Gruppe enthaltend Scandium, Yttrium, Lanthan, Gadolinium and Lutetium oder Mischungen daraus, M Molybdän, Wolfram oder Mischungen daraus, RE ein Seltenerdmetall ausgewählt aus der Gruppe Terbium, Dysprosium, Praseodym, wobei 0 <x ≤ 1 und 0 ≤y ≤ 0,05 ist.

2. Lichtemittierende Vorrichtung gemäß Anspruch 1, wobei die Bestromung des ein UV-A oder blaue Primärstrahlung emittierenden Halbleiterbauelements ≥ 2 A/mm² beträgt

3. Lichtemittierende Vorrichtung gemäß Anspruch 1 oder 2, wobei die Strahlungsleistung des ein UV-A oder blaue Primärstrahlung emittierenden Halbleiterbauelements ≥ 6 W/mm² beträgt

4. Lichtemittierende Vorrichtung gemäß einem der Ansprüche 1 bis 3, wobei das Konvertermaterial als keramisches Material vorliegt.

5. Lichtemittierende Vorrichtung gemäß einem der Ansprüche 1 bis 4, zusätzlich umfassend ein grün emittierendes Material.

6. Lichtemittierende Vorrichtung gemäß einem der Ansprüche 1 bis 5, zusätzlich umfassend ein Material aus der Gruppe umfassend BaMgAl₁₀O₁₇:Eu²⁺,Mn²⁺, (Sr₁₋ₓBaₓ)Si₂N₂O₂:Eu²⁺, (Sr₁₋ₓBaₓ)₂SiO₄:Eu²⁺, (Sr₁₋ₓBaₓ)₃SiO₅:Eu²⁺, (Sr₁₋ₓBaₓ)Ga₂S₄:Eu²⁺, (Lu₁₋ₓYₓ)₃(Al_{1-y}Ga_{y})₅O₁₂:Ce³⁺, (Lu₁₋ₓYₓ)₃(Al_{1-y}Sc_{y})₅O₁₂:Ce³⁺ oder Mischungen dieser Materialien.

7. Lichtemittierende Vorrichtung gemäß einem der Ansprüche 1 bis 6, zusätzlich umfassend ein gelb emittierendes Material.

8. Lichtemittierende Vorrichtung gemäß einem der Ansprüche 1 bis 7, zusätzlich umfassend ein Material ausgewählt aus der Gruppe enthaltend Ba₂Si₅N₈:Eu²⁺, (Ca₁₋ₓSrₓ)Si₂N₂O₂:Eu²⁺, (Y₁₋ₓGdₓ)₃(Al_{1-y}Ga_{y})₅O₁₂:Ce³⁺, (Y₁₋ₓTbₓ)₃(Al_{1-y}Ga_{y})₅O₁₂:Ce³⁺, SrLi₂SiO₄:Eu²⁺, (Ca₁₋ₓSrₓ)₂SiO₄:Eu²⁺, (Ca₁₋ₓSrₓ)₃SiO₅:Eu²⁺ oder Mischungen dieser Materialien

9. Lichtemittierende Vorrichtung gemäß einem der Ansprüche 1 bis 8, zusätzlich umfassend ein blau emittierendes Material.

## Claims

1. A light-emitting device, comprising a semiconductor component which emits UV-A or blue primary radiation and has a radiant flux of ≥ 4 Wopt/mm², and a converter material that predominantly contains a material that is selected from the list containing:
ALn₁₋ₓ₋yEuₓM₂O₈:RE_{y}
(Ln_{1-x-y}Euₓ)₂MO₆:RE_{2y}
(Ln_{1-x-y}Euₓ)₂M₂O₉:RE_{2y}
(Ln_{1-x-y}Euₓ)₂M₃O₁₂:RE_{2y}
(Ln_{1-x-y}Euₓ)₂M₄O₁₅:RE_{2y}
(Ln_{1-x-y}Euₓ)₆MO₁₂:RE_{6y}
(AE_{1-2x-y}EuₓA_{x+y})₃MO₆:RE_{3y}
A₃AE₂(Ln_{1-x-y}Euₓ)3(MO₄)₈:RE_{y}
or mixtures thereof, wherein, for each structure, independently of one another, A denotes an alkaline earth metal, i.e. selected from the group lithium, sodium, potassium, rubidium, cesium, or mixtures thereof, AE denotes an alkaline earth metal, i.e. selected from the group containing magnesium, calcium, strontium, barium, or mixtures thereof, Ln denotes a rare earth metal selected from the group containing scandium, yttrium, lanthanum, gadolinium, and lutetium, or mixtures thereof, M denotes molybdenum, tungsten, or mixtures thereof, and RE denotes a rare earth metal selected from the group terbium, dysprosium, praseodymium, where 0 < x ≤ 1 and 0 ≤ y ≤ 0.05.

2. The light-emitting device according to claim 1, wherein the current supply to the UV-A or blue primary radiation-emitting semiconductor component is ≥ 2 A/mm².

3. The light-emitting device according to claim 1 or 2, wherein the radiant flux of the UV-A or blue primary radiation-emitting semiconductor component is ≥ 6 W/mm².

4. The light-emitting device according to any one of claims 1 to 3, wherein the converter material is present as a ceramic material.

5. The light-emitting device according to any one of claims 1 to 4, additionally comprising a green-emitting material.

6. The light-emitting device according to any one of claims 1 to 5, additionally comprising a material from the group comprising BaMgAl₁₀O₁₇:Eu²⁺,Mn²⁺, (Sr₁₋ₓBaₓ)Si₂N₂O₂:Eu²⁺, (Sr₁₋ₓBaₓ)₂SiO₄:Eu²¹, (Sr₁₋Baₓ)₃SiO₅:EU²⁺, (Sr₁₋ₓBaₓ)Ga₂S₄:Eu²⁺, (Lu₁₋ₓYₓ)₃(Al_{1-y}Ga_{y})₅O₁₂:Ce³⁺, (Lu₁₋ₓYₓ)₃(Al_{1-y}Sc_{y})₅O₁₂:Ce³⁺, or mixtures of these materials.

7. The light-emitting device according to any one of claims 1 to 6, additionally comprising a yellow-emitting material.

8. The light-emitting device according to any one of claims 1 to 7, additionally comprising a material selected from the group containing Ba₂Si₅N₈:Eu²⁺, (Ca₁₋ₓSrₓ)Si₂N₂O₂:Eu²⁺, (Y₁₋ₓGdₓ)₃(Al_{1-y}Ga_{y})₅O₁₂:Ce³⁺, (Y₁₋ₓTbₓ)₃(Al_{1-y}Ga_{y})₅O₁₂:Ce³⁺, SrLi₂SiO₄:Eu²⁺, (Ca₁₋ₓSrₓ)₂SiO₄:Eu²⁺, (Ca₁₋ₓSrₓ)₃SiO₅:Eu²⁺, or mixtures of these materials.

9. The light-emitting device according to any one of claims 1 to 8, additionally comprising a blue-emitting material.

## Revendications

1. Dispositif électroluminescent, comprenant un composant semi-conducteur émettant un rayonnement primaire UV-A ou bleu d'une puissance de rayonnement ≥ 4 Wopt/mm² ainsi qu'un matériau convertisseur qui contient principalement un matériau sélectionné dans la liste contenant :
ALn_{1-x-y}EuₓM₂O₈:RE_{y}
(Ln_{1-x-y}Euₓ)2MO₆:RE_{2y}
(Ln_{1-x-y}Euₓ)₂M₂O₉:RE_{2y}
(Ln_{1-x-y}Euₓ)₂M₃O₁₂:RE_{2y}
(Ln_{1-x-y}Euₓ)₂M₄O₁₅:RE_{2y}
(Ln_{1-x-y}Euₓ)₆MO₁₂:RE_{6y}
(AE_{1-2x-y}EuₓA_{x+y})₃MO₆:RE_{3y}
A₃AE₂(Ln_{1-x-y}Euₓ)₃(MO₄)₈:RE_{y}
ou des mélanges de ceux-ci, dans lequel - pour chaque structure, indépendamment les unes des autres - A désigne un métal alcalino-terreux, c'est-à-dire choisi dans le groupe constitué du lithium, du sodium, du potassium, du rubidium, du césium ou de mélanges de ceux-ci, AE désigne un métal alcalino-terreux, c'est-à-dire choisi dans le groupe constitué du magnésium, du calcium, du strontium, du baryum ou de mélanges de ceux-ci, Ln désigne un métal de terre rare choisi dans le groupe constitué du scandium, de l'yttrium, du lanthane, du gadolinium et du lutétium ou de mélanges de ceux-ci, M désigne du molybdène, du tungstène ou des mélanges de ceux-ci, RE désigne un métal de terre rare choisi dans le groupe constitué du terbium, du dysprosium, du praséodyme, dans lequel 0 < x ≤ 1 et 0 ≤ y ≤ 0,05.

2. Dispositif électroluminescent selon la revendication 1, dans lequel l'alimentation en courant du composant semi-conducteur émettant un rayonnement primaire UV-A ou bleu est ≥ 2 A/mm².

3. Dispositif électroluminescent selon la revendication 1 ou 2, dans lequel la puissance de rayonnement du composant semi-conducteur émettant un rayonnement primaire UV-A ou bleu est ≥ 6 W/mm².

4. Dispositif électroluminescent selon l'une des revendications 1 à 3, dans lequel le matériau convertisseur est présent en tant que matériau céramique.

5. Dispositif électroluminescent selon l'une des revendications 1 à 4, comprenant en outre un matériau électroluminescent vert.

6. Dispositif électroluminescent selon l'une des revendications 1 à 5, comprenant en outre un matériau du groupe comprenant BaMgAl₁₀O₁₇:Eu²⁺,Mn²⁺, (Sr₁₋ₓBaₓ)Si₂N₂O₂:Eu²⁺, (Sr₁₋ₓBaₓ)₂SiO₄:Eu²⁺, (Sr₁₋ₓBaₓ)3SiO₅:Eu²⁺, (Sr₁₋ₓBaₓ)Ga₂S₄:Eu²⁺, (Lu₁₋ₓYₓ)₃(Al_{1-y}Ga_{y})₅O₁₂:Ce³⁺, (Lu₁₋ₓYₓ)₃(Al_{1-y}Sc_{y})₅O₁₂:Ce³⁺ ou des mélanges de ces matériaux.

7. Dispositif électroluminescent selon l'une des revendications 1 à 6, comprenant en outre un matériau électroluminescent jaune.

8. Dispositif électroluminescent selon l'une des revendications 1 à 7, comprenant en outre un matériau choisi dans le groupe contenant Ba₂Si₅N₈:Eu²⁺, (Ca₁₋ₓSrₓ)Si₂N₂O₂:Eu²⁺, (Y₁₋ₓGdₓ)₃(Al_{1-y}Ga_{y})₅O₁₂:Ce³⁺, (Y₁₋ₓTbₓ)₃(Al_{1-y}Ga_{y})₅O₁₂:Ce³⁺, SrLi₂SiO₄:Eu²⁺, (Ca₁₋ₓSrₓ)₂SiO₄:Eu²⁺, (Ca₁₋ₓSrₓ)₃SiO₅:Eu²⁺ ou des mélanges de ces matériaux.

9. Dispositif électroluminescent selon l'une des revendications 1 à 8, comprenant en outre un matériau électroluminescent bleu.
